# EUROPÄISCHE PATENTANMELDUNG

(11) **EP 1 956 709 A2**
(43) Veröffentlichungstag der Anmeldung: **13.08.2008**
(21) Anmeldenummer: 08000991.3
(22) Anmeldetag: 19.01.2008
(51) Int. Cl.: H03K 17/0812, H03K 17/66

(54) **Ansteuerschaltung mit TOP-Pegelumsetzer zur Übertragung eines Eingangssignals und zugeordnetes Verfahren**

(30) Priorität: 08.02.2007 DE 102007006319
(71) Anmelder: SEMIKRON Elektronik GmbH & Co. KG, 90431 Nürnberg (DE)
(72) Erfinder: Herzer, Reinhard, Dr., 98693 Ilmenau (DE); Roßberg, Matthias, 98693 Ilmenau (DE); Vogler, Bastian, 98693 Ilmenau (DE)

(57) **Zusammenfassung**

Die Erfindung beschreibt eine Ansteuerschaltung in leistungselektronischen Systemen mit einer Halbbrückenschaltung von zwei Leistungsschaltern, einem ersten sog. TOP-Schalter und einem zweiten sog. BOT- Schalter, die in einer Reihenschaltung angeordnet sind. Die Ansteuerschaltung weist einen TOP- Levelshifter zur Übertragung eines Eingangssignals von einer Ansteuerlogik zu einem TOP- Treiber auf. Hierbei ist der TOP- Levelshifter ausgebildet ist als eine Anordnung eines UP- und eines DOWN-Levelshifterzweiges sowie einer nachgeschalteten Signalauswerteschaltung. In dem zugeordneten Verfahren zur Übertragung dieses Eingangssignals übergibt die Signalauswerteschaltung ein Ausgangssignal an den TOP- Treiber, wenn entweder der UP- oder der DOWN-oder beide Levelshifterzweige ein Signal an den jeweils zugeordneten Eingang der Signalauswerteschaltung abgeben.

## Beschreibung

Die Erfindung beschreibt eine Ansteuerschaltung mit Levelshifter und ein zugehöriges Verfahren zur Übertragung eines Eingangssignals von einer Ansteuerlogik zu einem Treiber. Derartige Ansteuerschaltungen werden in leistungselektronischen Systemen benötigt um Leistungshalbleiterschalter anzusteuern, die als Einzelschalter oder in einer Brückenschaltung angeordnet sind. Derartige Brückenschaltungen sind als Ein-, Zwei-, oder Dreiphasen-Brückenschaltungen bekannt, wobei die einphasige sog. Halbbrücke einen Grundbaustein einer Vielzahl von leistungselektronischen Schaltungen darstellt. In einer Halbbrückenschaltung sind zwei Leistungsschalter, ein erster sog. TOP-Schalter und ein zweiter sog. BOT- Schalter in einer Reihenschaltung angeordnet.

Eine derartige Halbbrücke weist in der Regel eine Verbindung zu einem Gleichstromzwischenkreis auf. Der Ausgang, typischerweise der Wechselspannungsanschluss der Halbbrücke ist.meist mit einer Last verbunden. Die Ansteuerschaltung besteht in der Regel aus mehreren Teilschaltungen bzw. Funktionsblöcken. Das Steuersignal wird in einer ersten Teilschaltung, der Ansteuerlogik, aufbereitet und über weitere Komponenten den Treiberschaltungen und schließlich dem Steuereingang des jeweiligen Leistungsschalters zugeführt.

Bei höheren Zwischenkreisspannungen, beispielhaft größer 100V, wird meist die Ansteuerlogik potentialmäßig von den Treiberschaltungen getrennt, da sich die zugehörigen Leistungsschalter auf unterschiedlichem Potential befinden und somit eine spannüngsmäßige Isolation unumgänglich ist. Diese Trennung gilt zumindest für den TOP-Schalter, wird aber bei höheren Leistungen auch für den BOT- Schalter auf Grund eines möglichen Verrisses des Massepotentials beim Schalten ausgeführt. Eine derartige Trennung kann zum Beispiel durch Impulsübertrager, durch Optokoppler bzw. Lichtwellenleiter (galvanische Trennung) oder mit Hilfe integrierter Schaltungstechnik in einem HVIC (High Voltage Integrated Circuit) realisiert werden. Letztere Variante wird, aufgrund verschiedener Vorteile, wie geringe Abmessungen, niedriger Preis und lange Lebensdauer, mit zunehmender Häufigkeit eingesetzt. Gleichzeitig bieten HVICs die Möglichkeit, ein Hochspannungsbauelement, mit einer Durchbruchspannung größer oder gleich der Zwischenkreisspannung zu integrieren, welche in Schaltkreisen zur Signalpegelumsetzung, in sog. Levelshiftern, eingesetzt werden kann. Üblicherweise wird für diese ein lateraler Hochspannungs- MOSFET verwendet.

Der beschriebene Levelshifter ist Teil der Ansteuerschaltung und vorzugsweise ausgeführt als eine integrierte Schaltungsanordnung. Er dient der Übertragung eines Signals von einem Schaltungsteil mit einem definierten Bezugspotential zu einem Schaltungsteil mit einem zeitweise höheren oder niedrigeren Bezugspotential oder umgekehrt. Eine solche Anordnung wird zur integrierten und potentialgetrennten Ansteuerung von Leistungshalbleitern benötigt.

Es sind zwei grundsätzliche lsolationstechnologien zur Ausbildung von Levelshiftern bei HVICs bekannt. Einerseits die SOl-(Silicon on Insulator) Technologien und andererseits pn- isolierte Technologien (Junction Isolation). Die SOI- Technologie bietet eine dielektrische Isolation von Bauelementen und Bauelementgruppen, steht aber derzeit nur bis 800V Spannungsfestigkeit zur Verfügung. Die SOI- Substratwafer sind deutlich teurer als Standardsubstrate, allerdings werden die Kosten durch eine Reihe technischer Vorteile sowie erhebliche Prozessvereinfachungen kompensiert, die sich aus der dielektrischen Isolation ergeben. Bei pn- isolierten Technologien wird die Sperrspannung durch einen sperrgepolten pn- Übergang aufgenommen. Diese Technik steht derzeit bis 1200V zur Verfügung. Die Herstellung ist allerdings sehr aufwendig und somit kostenintensiv. Weiterhin gibt es technische Probleme, beispielhaft mit Leckströmen und Latch- up Effekten u.a. bei höheren Temperaturen, wie beispielhaft mehr als 125°C Betriebstemperatur, sowie bei Verriss des Massepotentials bei schnellen dynamischen Vorgängen.

Bei integrierten Ansteuerschaltungen ist nach dem Stand der Technik die Levetshifterübertragung der Ansteuersignale von der Ansteuerlogik zum TOP- Treiber bekannt. Dies ist notwendig, da der TOP- Treiber, im Unterschied zum BOT- Treiber, phasenweise auf einem erhöhten Bezugspotential liegt. Nach dem Stand der Technik erfolgt die.Signalübertragung von der Ansteuerseite zum TOP-Treiber mittels gepulster (dynamischer) und differentieller Übertragung, d.h. aus dem zu übertragenden Signal werden ansteuerseitig Ein- und Ausschaltpulse erzeugt, die über den jeweiligen Levelshifter auf den TOP- Treiber übertragen werden. Diese Art der Übertragung zeichnet sich durch eine große Übertragungssicherheit und geringen Leistungsbedarf aus. Es sind verschiedene integrierte Levelshiftertopologien bekannt. Die einfachste Topologie, bestehend aus einem HV₋ Transistor mit entsprechender Sperrfähigkeit und einem Widerstand, die in Reihe geschaltet sind. Wird ein Signal auf das Gate des HV- Transistors gegeben, schaltet dieser ein. Der dadurch erzeugte Querstrom durch den Levelshifter verursacht einen Spannungsabfall über dem Widerstand, der als Signal von einer Auswerteschaltung erfasst werden kann.

In DE 101 52 930 A1 wird eine erweiterte Levelshiftertopologie offenbart, bei der das Ansteuersignal schrittweise, mittels n gleichartig kaskadiert geschalteter bekannter Levelshifter, über n-1 Zwischenpotentiale übertragen wird. Damit lassen sich Transistoren einsetzen, die nur den n- ten Teil der geforderten Sperrfähigkeit des gesamten Levelshifters besitzen. Sind Transistoren mit der geforderten Sperrfähigkeit verfügbar kann die Sperrfähigkeit des Levelshifters um den Faktor n erhöht werden.

Die nicht vorveröffentlichte DE 10 2006 037 336 offenbart einen Levelshifter ausgeführt als eine Reihenschaltung von n in Reihe geschalteten HV-Transistoren. Diese Topologie weist die Vorteile auf, dass gegenüber DE 101 52 930 A1 zum einen der Leistungsverbrauch und zum anderen der Schaltungsaufwand verringert sind. Dies hat einen geringeren Platzbedarf und somit auch geringere Kosten zur Folge.

Allen bekannten Topologien ist gemein, dass bei komplementärem Aufbau des Levelshifters auch eine Signalübertragung von einem Schaltungsteil mit einem hohen Bezugspotential zu einem Schaltungsteil mit einem niedrigen Bezugspotential möglich ist. Diese Eigenschaft kann für eine Signalrückübertragung vom TOP- Treiber zur Ansteuerlogik genutzt werden.

Nach dem Stand der Technik werden bei integrierten Ansteuerschaltungen die Ansteuerlogik (Primärseite) und der BOT- Treiber (Sekundärseite) auf gleiches oder nur um wenige Volt voneinander abweichendes Bezugspotential gelegt, so dass keine Signalübertragung über Levelshifter notwendig ist. Dabei werden die Anschlüsse für das primärseitige bzw. sekundärseitige Bezugspotential meist extern kurzgeschlossen. Durch modul- und systeminterne Induktivitäten, beispielhaft Leitungsinduktivitäten, kann es jedoch während des Schaltens der Leistungsbauelemente zu einem starken Verriss des Bezugspotentials der BOT-Treiber in positiver oder negativer Richtung kommen. Dies tritt in besonders starkem Maße in Systemen mittlerer und hoher Leistung auf, bei denen große Ströme, beispielhaft größer 50A, geschaltet werden. Die Potentialdifferenz kann dabei Werte annehmen, die über die Sperrspannung der Gateoxide der verwendeten Transistoren, beispielhaft größer 20V, hinausgehen. Junction Isolation Technologien weisen den Nachteil auf, dass es bei einem entsprechenden Verriss des Bezugspotentials in negative Richtung zum Zünden parasitärer Thyristorstrukturen, sog. Latch-up, kommen kann. Dies führt zum Funktionsverlust und eventuell zur Zerstörung der betroffenen Bauelemente. Diese Einschränkung ist, bedingt durch die dielektrische Isolation der Bauelemente, bei SOI-Technologien nicht gegeben, so dass ein Levelshifter schaltungstechnisch umsetzbar ist, der auch bei kurzzeitig oder dauerhaft negativem sekundärseitigem Bezugspotential eine sichere Signalübertragung gewährleistet.

Die nicht vorveröffentlichte 10 2006 050 913 offenbart einen solchen Levelshifter für den BOT- Treiber in SOI- Technologie ausgeführt als UP- und DOWN-Levelshifterzweig. Allerdings ist diese Ansteuerschaltung für eine Brückentopologie nicht ausreichend, da auch das Bezugspotential des TOP- Treibers auf der Sekundärseite negativer als das Bezugspotential auf der Primärseite sein kann.

Der Erfindung liegt die Aufgabe zugrunde eine Ansteuerschaltung vorzugsweise in Form einer zumindest teilweise monolithisch integrierten Schaltung vorzustellen, wobei eine Signalübertragung zwischen Schaltungsteilen möglich ist, deren Bezugspotentialdifferenz über der Spannungsfestigkeit der Gateoxide der verwendeten Transistoren liegt.

Die Aufgabe wird erfindungsgemäß gelöst, durch die Maßnahmen der Merkmale der Ansprüche 1 und 8. Bevorzugte Ausführungsformen sind in den Unteransprüchen beschrieben.

Der erfinderische Gedanke geht aus von einer Ansteuerschaltung mit einem Levelshifter zur vorzugsweise unidirektionalen Übertragung eines Signals von einem ersten Schaltungsteil mit erstem Bezugspotential, beispielhaft die Primärseite eines integrierten Gatetreibers, zu einem zweiten Schaltungsteil mit zweitem Potential, beispielhaft die TOP-Sekundärseite eines integrierten Gatetreibers. Erfindungsgemäß wird diese Ansteuerschaltung weitergebildet durch einen TOP- Levelshifter zur potentialtrennenden Übertragung dieses Eingangssignal. Der TOP- Levelshifter selbst ist ausgebildet als eine Anordnung zweier unabhängig arbeitender Übertragungszweige, dem UP-und dem DOWN-Levetshifterzweig sowie einer nachgeschalteten Signalauswerteschaltung.

Der UP-Levelshifter überträgt das anliegende Eingangssignal von der Primärzur Sekundärseite, wenn das sekundärseitige Bezugspotential gleich oder größer ist als das primärseitige Bezugspotential. Der DOWN-.Levelshifter überträgt das anliegende Eingangssignal von der Primär- zur Sekundärseite, wenn das sekundärseitige Bezugspotential gleich oder kleiner ist als das primärseitige Bezugspotential. Es wird somit sowohl bei höherem als auch bei niedrigerem sekundärseitigem Bezugspotential gegenüber dem primärseitigen Bezugspotential mindestens ein gültiges Signal übertragen. Die Signalauswerteschaltung erfasst die Signale an den Ausgängen von UP- und DOWN- Levelshifter und rekonstruiert das übertragene Signal auf der Sekundärseite.

Das erfindungsgemäße Verfahren zur Übertragung eines Eingangssignals von der Ansteuerlogik zu einem TOP- Treiber innerhalb einer Ansteuerschaltung mit TOP-Levelshifter ist dadurch gekennzeichnet, dass die Signalauswerteschaltung ein Ausgangssignal an den TOP- Treiber übergibt, wenn entweder der UP- oder der DOWN- oder beide Levelshifterzweige ein Signal an den jeweils zugeordneten Eingang der Signalauswerteschaltung abgeben.

Die erfinderische Lösung wird an Hand der Fig. 1 bis 4 weiter erläutert.

Fig. 1 zeigt ein Blockschaltbild einer monolithisch integrierten Ansteuerschaltung nach dem Stand der Technik.

Fig. 2 zeigt eine ein Blockschaltbild einer erfindungsgemäßen monolithisch integrierten Ansteuerschaltung mit einem TOP- Levelshifter.

Fig. 3 zeigt die Grundschaltung eines TOP- Levelshifter einer erfindungsgemäßen Ansteuerschaltung.

Fig. 4 zeigt Simulationsergebnisse des erfindungsgemäßen Verfahrens.

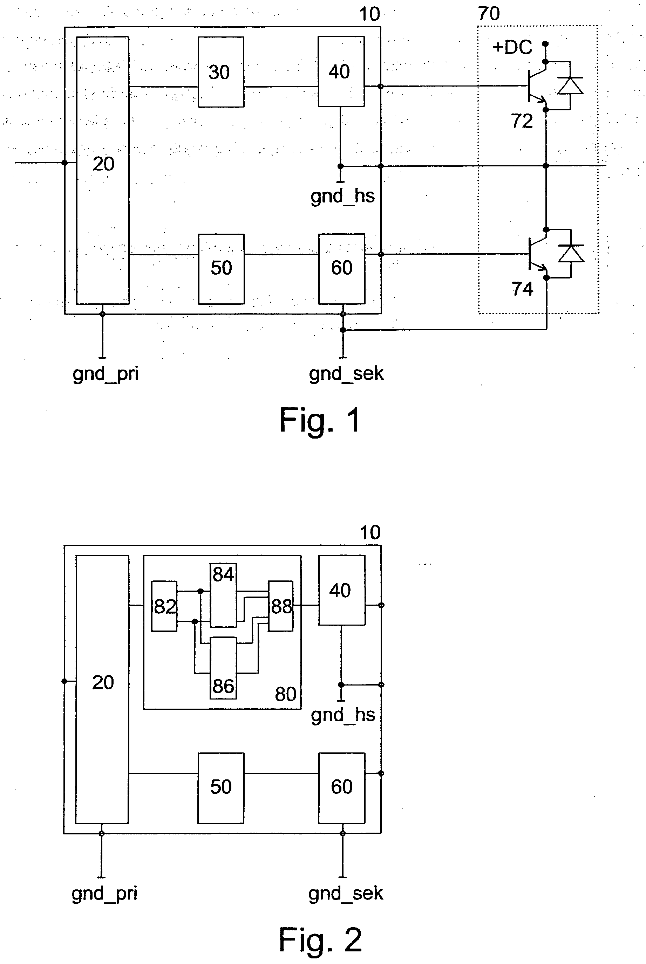

Fig. 1 zeigt eine monolithisch integrierte Ansteuerschaltung (10) nach dem Stand der Technik mit einer Halbbrückenschaltung (70). Diese Halbbrückenschaltung (70) weist gemäß dem Stand der Technik einen TOP-(72) und einen BOT Leistungsschalter (74) auf, die hier jeweils als ein IGBT mit antiparallel geschalteter Diode ausgebildet sind. Der BOT- Schalter (74) liegt auf dem Bezugspotential (gnd_sek) der Sekundärseite, welches bei Applikationen mit kleinen Leitungsinduktivitäten nahezu gleich dem Bezugspotential (gnd_pri) der Primärseite ist. Das Bezugspotential (gnd_pri) der Primärseite ist das Bezugspotential der Ansteuerschaltung (10).

Die Ansteuerschaltung (10) selbst weist eine Ansteuerlogik (20), einen TOP-Levelshifter (30) mit nachgeschaltetem TOP- Treiber (40) sowie einen BOT-Levelshifter (50) mit nachgeschaltetem BOT- Treiber (60) auf. Das Bezugspotential des BOT- Treiber (60) kann dabei höher, gleich oder niedriger als das Bezugspotential der Ansteuerlogik (20) liegen. Das Bezugspotential des TOP- Treiber (40) ist dabei höher oder gleich dem Bezugspotential der Ansteuerlogik (20).

Fig. 2 zeigt eine erfindungsgemäße monolithisch integrierte Ansteuerschaltung mit einem TOP- Levelshifter (80). Dieser bildet die erfindungsgemäße Weiterbildung des Standes der Technik gemäß Fig. 1. Der TOP- Schalter (72) liegt auf dem Bezugspotential (gnd_hs) der Sekundärseite, welches insbesondere bei Applikationen mit großen Leitungsinduktivitäten phasenweise nicht nur positiver sondern auch negativer als das Bezugspotential (gnd_pri) der Primärseite sein kann. Der TOP-Levelshifter (80) besteht hierbei aus einer Pulserzeugungsschaltung (82), aus einem UP- Levelshifterzweig (84), einem DOWN- Levelshifterzweig (86) und einer diesen nachgeschalteten Signalauswerteschaltung (88). Die Pulserzeugungsschaltung (82) liefert jeweils ein direktes, nicht invertiertes, und ein invertiertes Signal an den UP-Levelshifterzweig (84) sowie über einen inverter die dazu invertierten Signale an den DOWN- Levelshifterzweig (86). Der Ausgang der Signalauswerteschaltung (88) liegt am Eingang der TOP- Treiberstufe (40).

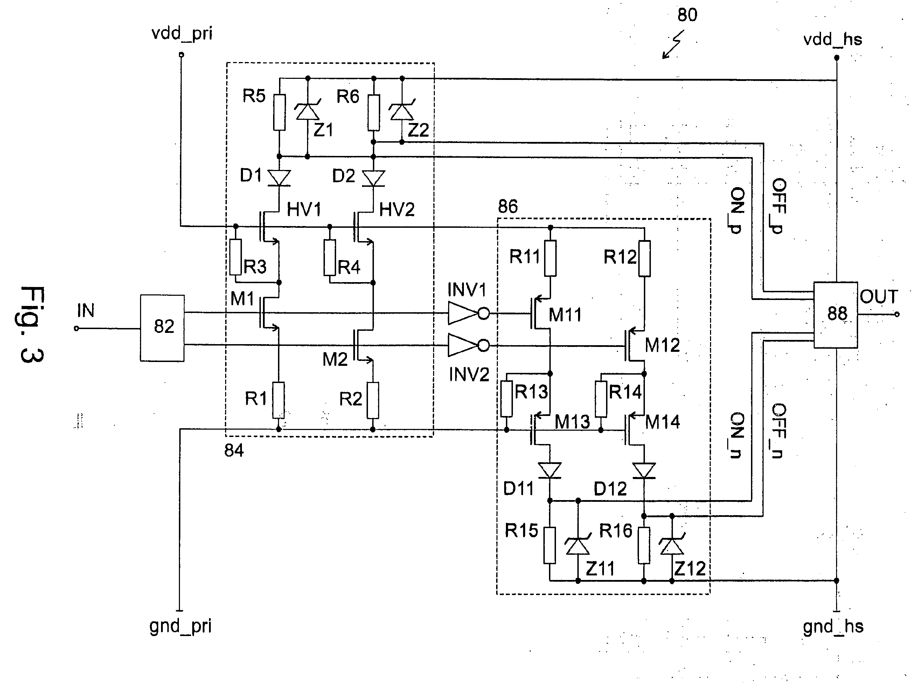

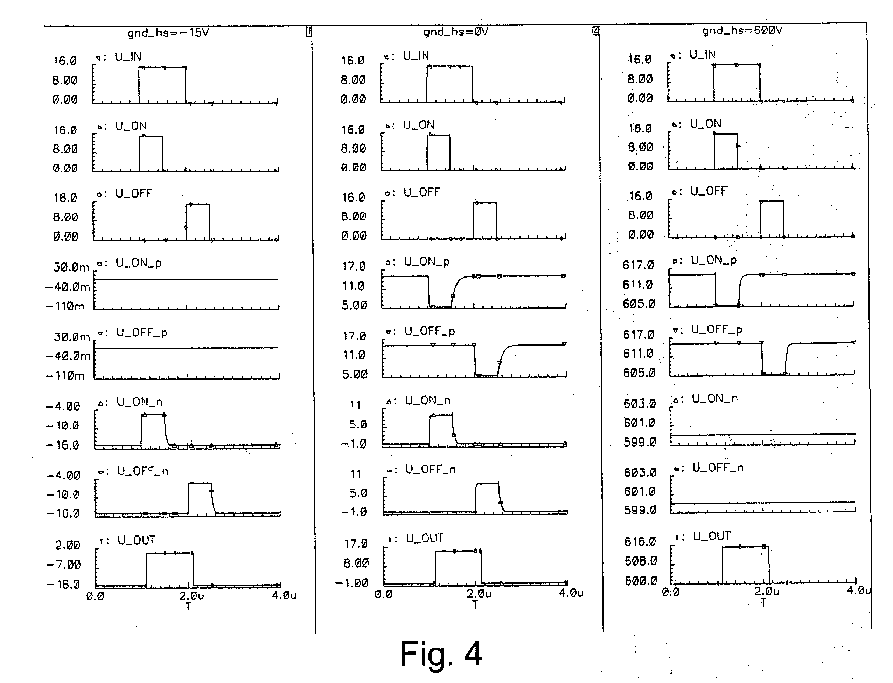

Fig. 3 zeigt einen TOP- Levelshifter (80) einer erfindungsgemäßen Ansteuerschaltung im Detail. Fig. 4 zeigt hierzu die Simulationsergebnisse des erfindungsgemäßen Verfahrens.

Der TOP- Levelshifter (80) weist hierbei zwei komplementäre Teile, den UP- (84) und DOWN-(86) Levelshifterzweig auf. Diese sind prinzipiell in Aufbau und Funktionsweise gleich, allerdings werden jeweils komplementäre Transistoren verwendet, d.h. n-Kanal Transistoren im UP- Levelshifterzweig werden durch p-Kanal Transistoren im DOWN- Levelshifterzweig ausgeführt und umgekehrt. Anschlüsse, die im UP- Levelshifterzweig (84) an der Versorgungsspannung vdd_hs anliegen, werden im DOWN- Levelshifterzweig (86) an das entsprechende Bezugspotential gnd_hs angelegt und umgekehrt. Das Bezugspotential gnd_hs ist dabei gleich dem Potential des Ausgangs der Halbbrücke (70). Der Aufbau des UP- und DOWN- Levelshifterzweiges wird im Weiteren erläutert.

Der UP- Levelshifterzweig (84) besteht seinerseits aus zwei Teilzweigen mit den Schalttransistoren M1 bzw. M2, den Hochspannungstransistoren HV1 bzw. HV2 jeweils vom n-Kanal-Typ, den Dioden D1 bzw. D2 sowie den Widerständen R1 und R5 bzw. R2 und R6. Diese Bauelemente des jeweiligen Teilzweiges sind in Reihe geschaltet. Die Source- Anschlüsse der Schalttransistoren M1 bzw. M2 sind über die Widerstände R1 bzw. R2 an das primärseitige Bezugspotential (gnd_pri) angeschlossen. Die Gates von M1 bzw. M2 sind mit dem ON- (nicht invertiert) bzw. OFF- (invertiert) Ausgang der Pulserzeugungsschaltung (82) verbunden und stellen die Steuereingänge des UP- Levelshifterzweiges dar. Die Gates von HV1 und HV2 sind an die primärseitige Versorgungsspannung (vdd_pri) angeschlossen. Die Drain-Anschlüsse von HV 1 bzw. HV2 sind jeweils mit den Kathoden der Dioden D1 bzw. D2 verbunden. Die Anoden der Dioden D1 bzw. D2 sind an die Widerstände R5 bzw. R6 angeschlossen. R5 und R6 sind außerdem mit der Versorgungsspannung vdd_hs verbunden. Die Anoden von D1 bzw. D2 bilden die Ausgänge ON_p bzw. OFF_p des UP- Levelshifterzweiges (84) und sind an die Signalauswerteschaltung (88) angeschlossen.

Analog besteht der DOWN- Levelshifterzweige (86) aus zwei Teilzweigen mit den Schalttransistoren M11 bzw. M12, den vorzugsweise spannungsfesteren Transistoren M13 bzw. M14 jeweils vom p-Kanal-Typ, den Dioden D11 bzw. D12 sowie den Widerständen R11 und R15 bzw. R12 und R16; Diese Bauelemente des jeweiligen Teilzweiges sind in Reihe geschaltet. Die Source- Anschlüsse der Schalttransistoren M11 bzw. M12 sind über die Widerstände R11 bzw. R12 an die primärseitige Versorgungsspannung (vdd_pri) angeschlossen. Die Gates von M11 bzw. M12 sind über die Inverter INV1 bzw. INV2 mit den ON- bzw. OFF-Ausgängen der Pulserzeugungsschaltung (82) verbunden und stellen die Steuereingänge des DOWN- Levelshifterzweiges dar. Die Gates von M13 und M14 sind an das primärseitige Bezugspotential (gnd_pri) angeschlossen. Die Drain-Anschlüsse von M13 bzw. M14 sind jeweils mit den Anoden der Dioden D11 bzw. D12 verbunden. Die Kathoden der Dioden D11 bzw. D12 sind an die Widerstände R15 bzw. R16 angeschlossen. R15 und R16 sind außerdem mit dem sekundärseitigen Bezugspotential gnd_hs verbunden. Die Kathoden von D11 bzw. D12 bilden die Ausgänge ON_n bzw OFF_n des Down-Levelshifterzweiges (86) und sind an die Signalauswerteschaltung (88) angeschlossen.

Die Z-Dioden Z1 und Z2 an den Widerständen R5 und R6 bzw. Z11 und Z12 an R15 und R16 begrenzen die Spannungen an den Ausgängen ON_p und OFF_p bzw. ON_n und OFF_n.

Die Widerstände R3 und R4 im UP- Levelshifterzweig (84) werden an den Betriebsspannungsanschluss (vdd_pri) der Primärseite und jeweils an das Source der Transistoren HV1 bzw. HV2 angeschlossen. Damit sind bei undefiniertem Zustand der Primärseite immer die Transistoren HV1 und HV2 ausgeschaltet. Die Widerstände R13 und R14 übernehmen an den Transistoren M13 bzw. M14 im DOWN-Levelshifterzweig (86) die analoge Funktion.

Die maximal zulässige positive Spannungsdifferenz zwischen primärseitigem und sekundärseitigem Bezugspotential wird durch die Drain- Source- Spannungsfestigkeit der Transistoren HV1 und HV2 bestimmt, für negative Spannungsdifferenzen durch die Drain- Source- Spannungsfestigkeit der Transistoren M13 und M14.

Die Signalübertragung über den UP- Levelshifterzweig (84) erfolgt nur wenn das Bezugspotential (gnd_hs) der Sekundärseite höher, genauso hoch oder geringfügig niedriger als das Bezugspotential (gnd_pri) der Primärseite ist. Im Folgenden wird die Funktionsweise des UP- Levelshifterzweiges (84) für diesen Fall beschrieben. Die entsprechenden Signalverläufe an den Ein- und Ausgängen bzw. den jeweiligen Knoten sind für den entsprechenden Betriebsfall in Fig. 4, Spalte 2 (gnd_hs= 0V) bzw. Spalte 3 (gnd_hs= 600V) dargestellt. Auf das Gate des Schalttransistors M1 wird ein von der Pulserzeugungsschaltung (82) aus einer positiven Flanke des Eingangssignals U_IN generiertes Steuersignal U_ON, beispielhaft ein rechteckförmiger Impuls, gegeben. Auf das Gate des Schalttransistors M2 wird ein von der Pulserzeugungsschaltung (82) aus einer negativen Flanke des Eingangssignals U_IN generiertes Steuersignal U_OFF, beispielhaft ein rechteckförmiger Impuls, gegeben. Die Steuersignale bewirken ein Einschalten jeweils eines der Transistoren M1 bzw. M2. Beim Einschalten von M1 wird ebenfalls der Transistor HV1 geöffnet bzw. beim Einschalten von M2 wird HV2 geöffnet (Kaskodeprinzip). Beim Einschalten fließt ein Querstrom Iquer durch den Levelshifterzweig. Die Höhe des Querstroms Iquer wird hauptsächlich durch die Widerstände R1 und R5 bzw. R2 und R6 bestimmt. Die Spannungsabfälle U_ON_p über dem Widerstand R5 bzw. U_OFF_p über R6 sind proportional zum Querstrom Iquer und stellen die jeweiligen Eingangssignale für die Signalauswerteschaltung (88) dar. Zusammenfassend wird das digitale Eingangssignal (U_IN) somit in Stromsignale gewandelt und so über den Levelshifter übertragen. Die angeschlossene Signalauswerteschaltung (88) wandelt das übertragene Signal Wieder in ein digitales Signal U_OUT zurück, welches dem Treiber (40) des TOP- Schalters übergeben wird.

Liegt das Bezugspotential (gnd_hs) der Sekundärseite unter einem bestimmten Wert, beispielhaft einige Volt, gegenüber der Primärseite, so wird die vorgegebene Einschaltschwelle, die in der Signalauswerteschaltung (88) von einer Schwellwerterfassungsschaltung, beispielhaft ein Komparator oder Schmitt- Trigger, vorgegeben wird, nicht erreicht. In diesem Fall wird das Eingangssignal U_IN nicht über den UP- Levelshifter übertragen. Die Ausgangsspannung des UP- Levelshifters entspricht dann dem Ausschaltzustand (U_ON_p=HIGH). Sinkt das Potential der Sekundärseite soweit ab, dass die Drain- Bulk- Dioden der Transistoren M1, M2, HV1 und HV2 in Durchlassrichtung gepolt würden, d.h. das sekundärseitige Versorgungspotential (vdd_sek) sinkt unter das primärseitige Bezugspotential (gnd_pri), dann sperren die Dioden D1 und D2 einen Stromfluss durch beide Teilzweige.

Analog erfolgt die Signalübertragung über den DOWN- Levelshifterzweig (86) nur, wenn das Bezugspotential (gnd_hs) der Sekundärseite kleiner, genauso hoch oder geringfügig höher als das Bezugspotential (gnd_pri) der Primärseite ist. Die entsprechenden Signalverläufe an den Ein- und Ausgängen bzw. den jeweiligen Knoten sind für den entsprechenden Betriebsfall in Fig. 4, Spalte 1 (gnd_hs= -15V) bzw. Spalte 2 (gnd_hs= 0V) dargestellt. Auf das Gate des p-Kanal Schalttransistors M11 wird ein von der Pulserzeugungsschaltung (82) aus einer positiven Flanke des Eingangssignals U_IN generiertes Steuersignal U_ON invertiert gegeben. Auf das Gate des p-Kanal Schalttransistors M12 wird ein von der Pulserzeugungsschaltung (82) aus einer negativen Flanke des Eingangssignals U_IN generiertes Steuersignal U_OFF invertiert gegeben: Die Steuersignale bewirken ein Einschalten jeweils eines der Transistoren M11 bzw. M12. Beim Einschalten von M11 wird ebenfalls der p-Kanal Transistor M13 geöffnet bzw. beim Einschalten von M12 wird M14 geöffnet (Kaskodeprinzip). Beim Einschalten fließt ein Querstrom Iquer durch den Leveishifterzweig. Die Höhe des Querstroms Iquer wird hauptsächlich durch die Widerstände R11 und R15 bzw. R12 und R16 bestimmt. Die Spannungsabfälle U_ON_n über dem Widerstand R15 bzw. U_OFF_n über R16 sind proportional zum Querstrom Iquer und stellen die jeweiligen Eingangssignale für die Signalauswerteschaltung (88) dar. Damit kann auch unter diesen Potentialverhältnissen zwischen sekundärseitigem Bezugspotential (grd_hs) und primärseitigem Bezugspotential gnd_pri ein Signal U_IN sicher übertragen werden, welches als Ausgangssignal U_OUT dem Treiber (40) des TOP- Schalters übergeben wird.

Liegt das Bezugspotential (gnd_hs) der Sekundärseite über einem bestimmten Wert, beispielhaft einige Volt gegenüber der Primärseite (gnd_pri), wird die vorgegebene Einschaltschwelle, die in der Signalauswerteschaltung (88) von einer Schwellwerterfassungsschaltung, beispielhaft ein Komparator oder Schmitt- Trigger, vorgegeben wird, nicht erreicht. In diesem Fall wird das Eingangssignal U_IN nicht über den DOWN- Levelshifter übertragen. Die Ausgangsspannung des DOWN-Levelshifters entspricht dann dem Ausschaltzustand (U_ON_n=LOW). Steigt das Potential der Sekundärseite soweit an, dass die Drain- Bulk- Dioden der Transistoren M11 bis M14 in Durchlassrichtung gepolt würden, d.h. das sekundärseitige Bezugspotential (gnd_hs) steigt über das Potential der primärseitigen Versorgungsspannung (vdd_pri), dann sperren die Dioden D11 und D12 einen Stromfluss durch beide Teilzweige.

Befindet sich das Bezugspotential (gnd_hs) der Sekundärseite innerhalb eines Bereiches einige Volt über bzw. unterhalb des Bezugspotentials (gnd_pri) der Primärseite, dann übertragen sowohl der UP- (84) als auch der DOWN- (86) Levelshifterzweig gültige Signale von der Primär- auf die Sekundärseite (siehe Fig. 4, Spalte 2 (gnd_hs= OV)). Durch diesen überlappenden Bereich ist eine sichere Signalübertragung auch unter Berücksichtigung von Exemplarstreuungen der Übertragungsschwellen, durch technologisch bedingte Schwankungen von Bauelementeparametern sowie bei schnellen Änderungen des sekundärseitigen Bezugspotentials gewährleistet. Dies erhöht die Störsicherheit des Levelshifters (80).

Die Signalauswerteschaltung (88) erzeugt ein gültiges Ansteuersignal (U_OUT) für den TOP-Treiber (40) wenn entweder ein Signal über den UP- Levelshifterzweig (84) (siehe Fig. 4, Spalte 3 (gnd_hs=600V)) oder den DOWN- Levelshifterzweig (86) (siehe Fig. 4, Spalte 1 (gnd_hs= -15V)) oder über beide- Levelshifterzweige (siehe Fig. 4, Spalte 2 (gnd_hs= 0V)) gleichzeitig übertragen wird (ODER- Verknüpfung).

In Fig. 4 ist das transiente Übertragungsverhalten des Levelshifters (80) gemäß Fig. 3 im Rahmen einer Simulation, bei negativem Bezugspotential der Sekundärseite (gnd_hs=-15V, Spalte 1), bei gleichem Bezugspotential von Primär- und Sekundärseite (gnd_hs=0V, Spalte 2) und bei positivem Bezugspotential der Sekundärseite (gnd_hs=600V, Spalte 3), dargestellt. Das Bezugspotential (gnd_pri) der Primärseite liegt dabei immer auf Massepotential (0V). Es wurde jeweils das gleiche rechteckförmige Ansteuersignal U_IN auf den Eingang IN gegeben. Aus der Abbildung ist ersichtlich, dass bei gleichem Bezugspotential von Primär- und Sekundärseite (Spalte 2) sowohl an den Ausgängen des UP- Levelshifters (U_ON_p, U_OFF_p) als auch den Ausgängen des DOWN- Levelshifters (U_ON_n, U_OFF_n) ein übertragenes Signal erscheint, wohingegen bei negativem Bezugspotential nur am Ausgang des DOWN- Levelshifters (Spalte 1; U_ON_n, U_OFF_n) bzw. bei positivem Bezugspotential nur am Ausgang des UP- Levelshifters (Spalte 3; U_ON_p, U_OFF_p) ein übertragenes Signal erscheint und der Ausgang des entsprechenden komplementären Levelshifterzweiges im Ausschaltzustand verharrt. In allen drei Fällen erkennt die Signalauswerteschaltung, dass mindestens ein Signal über den UP- und/oder DOWN- Levelshifterzweig übertragen wurde und gibt ein gültiges Ausgangssignal U_OUT aus. Der Levelshifter (80) zeigt somit das gewünschte Verhalten.

## Patentansprüche

1. Ansteuerschaltung (10) mit TOP- Levelshifter (80) zur Übertragung eines Eingangssignals (IN) von einer Ansteuerlogik (20) zu einem TOP- Treiber (40),
wobei der TOP-Levelshifter (80) ausgebildet ist als eine Anordnung einer Pulserzeugungsschaltung (82), eines UP- (84) und eines DOWN- (86) Levelshifterzweiges sowie einer nachgeschalteten Signalauswerteschaltung (88).

2. Ansteuerschaltung (10) nach Anspruch 1,
wobei innerhalb des TOP- Levelshifters (80) der UP- Levelshifterzweig (84) im Wesentlichen komplementär zum DOWN- Levelshifterzweig (86) ausgebildet ist:

3. Ansteuerschaltung nach Anspruch 1,
wobei die Ausgänge (ON_p, OFF_p) des UP- Levelshifterzweiges (84) und die Ausgänge (ON_n, OFF_n) des DOWN- Levelshifterzweiges (86) mit den Eingängen der Signalauswerteschaltung (88) verbunden sind und der Ausgang der Signalauswerteschaltung (OUT) das Eingangssignal für den TOP- Treiber (40) bildet.

4. Ansteuerschaltung nach Anspruch 1,
wobei die Ansteuerlogik (20), der TOP- Levelshifter (80) und der TOP- Treiber (40) monolithisch integriert sind.

5. Ansteuerschaltung nach Anspruch 1,
wobei der UP- Levelshifterzweig (84) gebildet wird aus zwei Teilzweigen, die ihrerseits gebildet werden aus der seriellen Anordnung von je zwei n-Kanal Transistoren M1, HV1 bzw. M2, HV2 in Kaskodeschaltung, je einer Diode D1 bzw. D2 und je zwei Widerständen R1, R5 bzw. R2, R6, wobei die Source- Anschlüsse der Schalttransistoren M1 bzw. M2 über die Widerstände R1 bzw. R2 an das primärseitige Bezugspotential (gnd_pri) angeschlossen sind, die Gates von M1 bzw. M2 als Steuereingänge des UP- Levelshifterzweiges mit dem ON- bzw. OFF-Ausgang der Pulserzeugungsschaltung (82) verbunden sind, die Gates von HV1 und HV2 an die primärseitige Versorgungsspannung (vdd_pri) angeschlossen sind, die Drain- Anschlüsse von HV1 bzw. HV2 mit den Kathoden der Dioden D1 bzw. D2 verbunden sind und die Anoden von D1 bzw. D2 wiederum einerseits die Ausgänge ON_p bzw. OFF_p des UP- Levelshifterzweiges (84) zur Signalauswerteschaltung (88) bilden und andererseits über die Widerstände R5 bzw. R6 mit der Versorgungsspannung vdd_hs verbunden sind.

6. Ansteuerschaltung nach Anspruch 1,
wobei der DOWN- Levelshifterzweig (86) gebildet wird aus zwei Teilzweigen, die ihrerseits gebildet werden aus der seriellen Anordnung von je zwei p-Kanal, Transistoren M11, M13 bzw. M12, M14 in Kaskodeschaltung, je einer Diode D11 bzw. D12 und je zwei Widerständen R1, R15 bzw. R12, R16, wobei die Source-Anschlüsse der Schalttransistoren M11 bzw. M12 über die Widerstände R11 bzw. R12 an die primärseitige Versorgungsspannung (vdd_pri) angeschlossen sind, die Gates von M11 bzw. M12 als Steuereingänge des DOWN- Levelshifterzweiges mit den invertierten ON- bzw. invertierten OFF- Ausgängen der Pulserzeugungsschaltung (82) verbunden sind, die Gates von M13 und M14 an das primärseitige Bezugspotential (gnd_pri) angeschlossen sind, die Drain- Anschlüsse von M13 bzw. M14 mit den Anoden der Dioden D11 bzw. D12 verbunden sind und die Kathoden von D11 bzw. D12 wiederum einerseits die Ausgänge ON_n bzw. OFF_n des DOWN- Levelshifterzweiges (86) zur Signalauswerteschaltung (88) bilden und andererseits über die Widerstände R15 bzw. R16 mit dem Bezugspotential gnd_hs verbunden sind.

7. Ansteuerschaltung nach Anspruch 1,
wobei das Bezugspotential des TOP- Treibers (gnd_hs) bis zum Betrag der maximal möglichen Spannungsfestigkeit des UP- und DOWN- Levelshifterzweigs (84, 86) um das Bezugspotential der Ansteuerlogik (gnd-pri) schwanken kann, ohne das ein Funktionsverlust auftritt.

8. Verfahren zur Übertragung eines Eingangssignals (U_IN) von der Ansteuerlogik (20) zu einem TOP-Treiber (40) innerhalb einer Ansteuerschaltung (10) mit TOP-Levelshifter (80) nach Anspruch 1,
wobei die Signalauswerteschaltung (88) ein Ausgangssignal (U_OUT) an den TOP-Treiber (40)übergibt, wenn entweder der UP- (84) oder der DOWN- (86) oder beide Levelshifterzweige gültige Steuersignale (U_ON_p / U_OFF_p, U_ON_n/ U_OFF_n) an den jeweiligen zugeordneten Eingang der Signalauswerteschaltung (88) abgeben.

9. Verfahren nach Anspruch 8,
wobei der UP- Levelshifterzweig (84) gültige Steuersignale an die zugeordneten Eingänge der Signalauswerteschaltung (88) abgibt, wenn das sekundärseitige Bezugspotential (gnd_hs) nahezu gleich oder höher als das primärseitige Bezugspotential (gnd_pri) ist und der DOWN- Levelshifterzweig (86) gültige Steuersignale an die zugeordneten Eingänge der Signalauswerteschaltung (88) abgibt, wenn das sekundärseitige Bezugspotential (gnd_hs) nahezu gleich oder niedriger als das primärseitige Bezugspotential (gnd_pri) ist.
